# EUROPEAN PATENT SPECIFICATION

(11) **EP 2 800 161 B1**
(45) Date of publication and mention of the grant of the patent: **22.01.2020**
(21) Application number: 13166037.5
(22) Date of filing: 30.04.2013
(51) Int. Cl.: H01L 51/42, G02B 1/11, H01L 51/44

(54) **Semitransparent photoconversion device**
Semitransparente Fotowandlervorrichtung
Dispositif de photoconversion semi-transparente

(43) Date of publication of application: 05.11.2014
(73) Proprietor: Fundació Institut de Ciències Fotòniques, 08860 Castelldefels (Barcelona) (ES); Universitat Politècnica De Catalunya, 08034 Barcelona (ES)
(72) Inventor: Martorell Pena, Jordi, 08860 Castelldefels (Barcelona) (ES); Betancur Lopera, Rafael, Andrés, 08860 Castelldefels (Barcelona) (ES); Ronero Gómez, Pablo, 08860 Castelldefels (Barcelona) (ES); Martínez Otero, Alberto, 08860 Castelldefels (Barcelona) (ES)
(74) Representative: Carpintero Lopez, Francisco

(56) References cited:
- EP-A1- 2 262 024
- US-A1- 2005 266 218
- US-A1- 2012 186 623
- US-A1- 2013 008 509
- DONGGEON HAN ET AL: "Realization of efficient semitransparent organic photovoltaic cells with metallic top electrodes: utilizing the tunable absorption asymmetry", OPTICS EXPRESS, vol. 18, no. S4, 8 November 2010 (2010-11-08), page A513, XP055076761, ISSN: 1094-4087, DOI: 10.1364/OE.18.00A513
- M. Y. KUO ET AL: "Quantum efficiency enhancement in selectively transparent silicon thin film solar cells by distributed Bragg reflectors", OPTICS EXPRESS, vol. 20, no. S6, 19 September 2012 (2012-09-19), pages A828-A835, XP055076813, Washington DC, (US) ISSN: 1094-4087, DOI: 10.1364/OE.20.00A828

## Description

### TECHNICAL FIELD

The present invention relates to photoconversion devices such as photovoltaic cells or photodetectors. More in particular, the invention is related to a light transmissive layered photonic structure to enhance light harvesting and tune the color of a transparent photovoltaic device.

### BACKGROUND OF INVENTION

Photovoltaic energy sources integration in buildings is of the upmost importance to reduce building emissions. Semi-transparent cells offer a high degree for integration provided they can be incorporated in buildings as windows panes, curtain walls or double skin façades, causing a minimal alteration to the vision of the building users and the exterior appearance of the building. When considering a semitransparent photovoltaic technology there are four important aspects that must be approached: harvesting of those photons which are invisible to the human eye, maximizing transparency to the visible light, device lifetime, and the esthetic appearance from a building wall that incorporates such photovoltaic technology. To increase light harvesting for invisible photons in organic semi-transparent devices several techniques and methods of manufacturing the same have been disclosed:
Y. Galagan et al./Applied Physics Letters 98 (2011) Art. No. 043302 reports on the use of a cholesteric liquid crystal to reflect only in a narrow band of the solar spectrum and remain transparent for the other wavelengths.

R. R. Lunt et al./Applied Physics Letters 98 (2011) Art. No. 113305 reports on the use of a distributed Bragg reflector mirror to increase reflectivity in the infrared which subsequently increases the efficiency of a low efficiency transparent organic solar cell.
To increase transparency in the visible for the top metal electrode, different kinds of electrodes have been disclosed: Pat. No. CN101593812 A and Tao, C. et al./Applied Physics Letters 95 (2009), Art. No. 053303 discloses a transparent anode which adopts a multilayer structure and comprises an anode buffer layer, a metal thin layer and an anti-reflection film. By introducing the anti-reflection film, the energy conversion efficiency of the semitransparent inverse organic solar cell can be improved. By changing the thickness of the anti-reflection film, the transmission spectrum of the transparent anode can be adjusted.

Semi-transparent photovoltaic devices can be made using several kinds of thin film photovoltaic technologies such as CIGS, amorphous silicon, or dye sensitized cells. However, the strong absorption at short visible wavelengths in all such cases leads to a yellowish or reddish color hue to objects that are being observed through such type of devices. On the other hand, the wavelength dependent absorption of some photovoltaic polymer blends such as PBDTTT-C:PCBM or PTB7:PCBM does not exhibit any highly pronounced features in the visible range. Consequently, when looking through a thin layer of such a blend, one does not perceive any significant alteration of the color hue of any kind of image behind. In fact, the only visual effect of such blend to the image being observed through is a reduction in the light intensity received by the eye

Several mechanisms to alter the color or other properties of transparent photovoltaic devices have been disclosed:
US 2009/0277500 A1 discloses color tuning of cells by packaging together a transparent solar cell coated on a first transparent subtrate with a an optical filter coated on a second transparent substrate. The cell and filter are packaged together using an insulating layer as ethylene vinyl acetate (EVA), polyvinyl butyral (PVB), or another similar material. No fine control (100 nm resoltion or less) can be provided over the thickness of such insulating layer, which prevents any improvement on the performance of the transparent solar cell module. In other words, US 2009/0277500 discloses two separate devices which are bound together with a layer of insulating material. The lack of thickness control over such insulating layer implies that the optical filter acts as a stand alone device having no direct effect on the performance of the solar cell device.
KR101140731 B1 discloses a transmission type photovoltaic module of various colors by utilizing interference color of a 3D photonic crystal.

US2005226218 shows a photo-conversion device with a multilayer structure of alternating layers of high and low refractive indexes. Alternatively one may tune the device color perception to the observer by introducing an absorbing layer to alter the wavelength dependent transmission and eventually modify the color appearance.

### SUMMARY OF THE INVENTION

The main object of the present invention is to provide a semi-transparent photo conversion device that enhances harvesting of visible sunlight. For this purpose, a semitransparent photovoltaic cell is provided with a multilayer structure that can be used to increase the efficiency, increase the lifetime, and change the color hue appearance of the cell while guaranteeing a minimum change to the light absorption capacity. In particular, the invention discloses a photoconversion device comprising a transparent substrate and a first light transmissive electrical contact overlaying the transparent substrate, a first charge blocking layer, an absorption layer comprising and active organic photosensitive material, a second charge blocking layer overlying the active organic photosensitive material, a second light transmissive electrical contact and a multilayer structure in this order, the multilayer structure comprising at least two layers of different dielectric materials with different index of refraction and wherein the thickness of each layer is between 5 and 500 nm and two adjacent layers have different refractive indexes, wherein the multilayer structure comprises five layers of MoO3 and MgF2 in an alternating fashion or six layers of LiF and MoO3 in an alternating fashion. Other aspects of the invention are apparent form the dependent claims.

### BRIEF DESCRIPTION OF THE DRAWINGS

To complete the description and in order to provide for a better understanding of the invention, a set of drawings is provided.

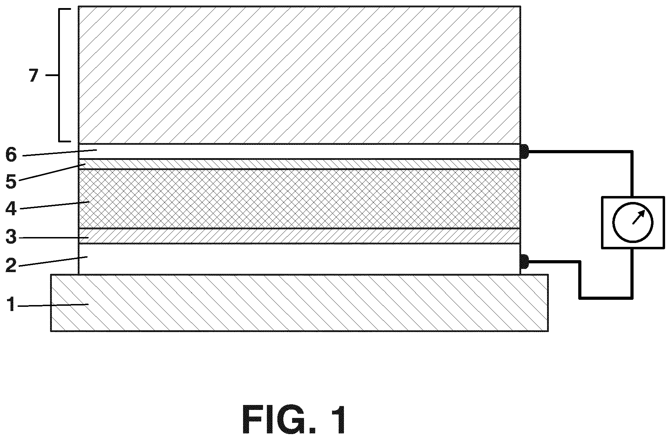

Figure 1 is a schematic cross-sectional view of a transparent solar cell including a multilayer structure.
Figure 2 is a graph showing the absorbed photons by the invention and a semi-transparent cell which does not include the multilayer structure.
Figure 3 is a graph comparing the light transmission curves of two different examples of the semi transparent photovoltaic cell of the present invention
Figure 4 is a graph showing the absorbed photons by the invention and a semi-transparent cell which does not include the multilayer structure.
Figure 5 is a graph showing (theory and experiment) the absorbed photons by the invention and a semi-transparent cell which does not include the multilayer structure.
Figure 6 is a graph comparing the light transmission curves by the present invention and a semi-transparent cell which does not include the multilayer structure. The experimental devices considered in this figure are the same ones considered in Figure 5.
Figure 7 is a graph comparing the lifetimes by the present invention and a semi-transparent cell which does not include the multilayer structure. The device configurations considered in this figure are the same ones considered in Figure 2.

### DETAILED DESCRIPCTION OF THE INVENTION

The photo conversion device has a direct or inverted architecture that comprises a first light transmissive electrical contact overlaying a transparent substrate, a charge blocking layer overlying the first light transmissive electrical contact and underlying the active organic photosensitive material, a second charge blocking layer overlying the active organic photosensitive material, a second light transmissive electrical contact overlying the second charge blocking layer, and a multilayer structure overlying the second light transmissive electrical contact. The multilayer structure is composed of two or more layers of dielectric materials. In such multilayer structure, the index of refraction of each layer must be different than the index of refraction of the adjacent layers. A method for manufacturing the photovoltaic cell including the multilayer structure comprises one deposition step for each layer in the device. The manufacturing of the entire device finishes with the deposition of the last dielectric layer from the multilayer structure.

More in particular, in a preferred embodiment the device is an inverted organic solar cell comprising:
1 A substrate of any light transmissive rigid or flexible material on which the photovoltaic cell can be grown upon as glass, crystal, transparent metal, semiconductor or plastic. Examples of these materials are silica (Si02), borosilicate (BK7) and PET.
2 A first transparent electrode comprising a thin metal layer or nanowire mesh from the elements of the group of Ag, Al, Au, Ti, Ni, Cu, or combinations thereof, or a transparent conductive oxide layer from the group of ITO, ZnO, Al:ZnO, Sn02, FTO, or conductive polymers such as PEDOT, PEDOT:PSS, PEDOT-TMA or a carbon nanotube, or a graphene layer of a thickness between 0.3 nm and 350 nm.
3 Overlying and in contact with the first electrode there is a hole blocking layer comprising a transparent semi-conductor layer as ZnO, PFN, or Ti02 (thickness between 1 nm and 150 nm) . The layer comprises either a homogenous or a nanoparticle morphology of the materials listed.
4 An organic active material forming a blend that contains a mixture of two components: a semiconductor conjugated polymer and a fullerene compound. The first component is a conjugated polymer with alternating electron-donor and electron-acceptor monomers. The donor is a derivative of benzo[1,2-b:4,5-b']dithiophene, whereas as acceptor many different types of compounds can be used, for example, though not exclusively, thiophene, benzothiadiazole or diketopyrrolopyrrole derivatives. Alternatively, the first component is a α-PTPTBT polymer, where the electron donating unit is a thiophene-phenylene-thiophene (TPT) and the acceptor unit is 2,1,3-benzothiadiazole (BT). Alternatively, the first component is a polythiophene polymer (P3HT). The second component of the blend is C₆₀ or a soluble derivative of the fullerene family of compounds. The thickness of the whole active material layer is between 40 nm and 500 nm. Alternatively, the active material may comprise a stack of two or more of such blends forming a tandem organic active layer in a series configuration. The separation between the blends in the stack may comprise an interlayer for facilitating recombination of holes and electrons.
5 An electron blocking layer comprising a transparent semi-conductor layer as Mo03, PEDOT:PSS, WO3, NiO (1 nm and 150 nm). The layer may comprise either a homogenous or a nanoparticle morphology of the materials listed above.
6 A second transparent electrode may comprise a thin metal layer or nanowire mesh from the elements of the group of Ag, Al, Au, Ti, Ni, Cu,... or combinations thereof, or a transparent conductive oxide layer from the group of ITO, ZnO, Al:ZnO, Sn02, FTO, or conductive polymers such as PEDOT, PEDOT:PSS, PEDOT-TMA or a carbon nanotube, or a graphene layer. (0.3 nm up to 350 nm)
7 A multilayer structure comprising five layers of MoO3 and LiF in an alternating fashion or six layers of LiF and MoO3 in an alternating fashion.

A multilayer structure of the prior art may comprise
two or more dielectric layers. In this multilayer structure each dielectric layer may comprise a transparent inorganic material such as Mo03, MgF2, Ti02, Si02, SiN1.3:H, Si02:F, Ta205, ZnO, Al2O3, ZnS,CaF2, Mb05, Zr02, Y203, Si02:H, LiF. Each layer may comprise either a homogenous or a nanoparticle morphology of the inorganic materials listed above. Alternatively the layer may comprise transparent polymer materials such as PMMA, Polystyrene, PET. The thickness of each layer within the multilayer structure is between 5 nm and 500 nm. The range of thicknesses is such because the thickness of each one of the dielectric layers has a direct effect on the performance (efficiency, lifetime, transparency and color) of the entire device.

The first layer in the multilayer structure of the prior art comprises one of the dielectric materials above or a mixture of them. The second layer in the multilayer structure comprises one of the materials above but not the same one or same mixture as in the first layer in the sense that the index of refraction for the second layer must be different than the index of the first layer in the multilayer structure. The third layer in the multilayer structure comprises a material from the list above with an index of refraction different than the index of the second layer in the multilayer structure. This sequence is repeated up to the last layer of the structure. In a preferred embodiment for the multilayer structure the material used in all the odd layers is the same while the material used in all even layers is the same.

Alternatively, the device is a direct organic cell comprising the same elements as before, but where an electron blocking layer comprising a transparent semi-conductor layer as PEDOT:PSS, NiO, WO3, MoO3 of a thickness between 1 and 150 nm is provided on top of the first transparent electrode and a hole blocking layer comprising a transparent semi-conductor layer as ZnO, PFN, BCP, TiO2, LiF, LiCoO2 of a thickness between 1 and 150 nm is provided on top of the active material.

Below there are three inventive examples where the optimal thicknesses for the dielectric layers in the multilayer structure are provided. As can be seen such optimal thicknesses are different in each case but they are always within the range specified. A fourth inventive example is to demonstrate that the multilayer structure increases the operation lifetime of the device by providing an effective barrier to corrosive elements such as oxygen or moisture.

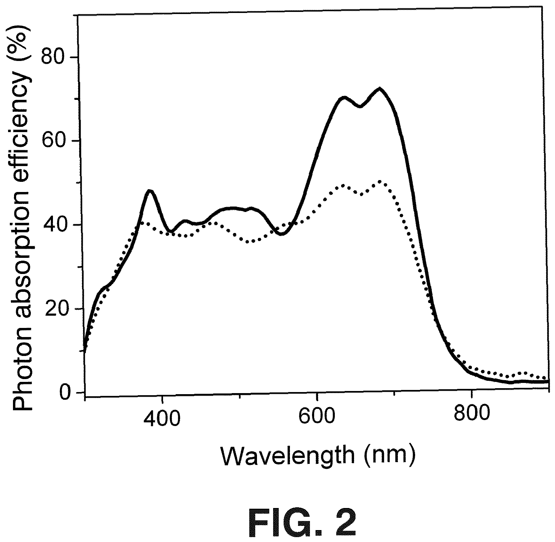

Figure 2 is a graph comparing the photon absorption by the invention (solid line) and by a semi-transparent cell which does not include the multilayer structure. The absorbed photons are proportional to the photo-carrier generation efficiency. For this graph, the embodiment of the invention comprises: a 1.1 mm thick Si02 substrate, a first semi-transparent 120 nm thick ITO electrode, a hole blocking layer of 30 nm thick ZnO, an active material made of a 100 nm blend of PTB7:PC₇₁BM, an electron blocking layer of a thickness of 5 nm made of Mo03, a second semi-transparent electrode made of Ag and 10 nm thick, and the multilayer structure. The latter comprises five layers: 102 nm of Mo03, 136 nm of MgF2, 102 nm of Mo03, 102 nm of MgF2, and 102 nm of Mo03. The semi-transparent cell without the multilayer structure (dotted line) is composed of the same elements and a protective layer of Mo03 10nm thick, but is not provided with the multilayer structure.
As it can be seen in the figure, photon absorption by the invention is enhanced for light wavelengths to which the human eye is most insensitive. Photon absorption in the wavelength range (400-600 nm) where the eye sensitivity is the largest is however similar to photon absorption by the semi-transparent cell which does not include the multilayer structure. In other words, the invention is more efficient in converting light to electricity with the same visible transparency.

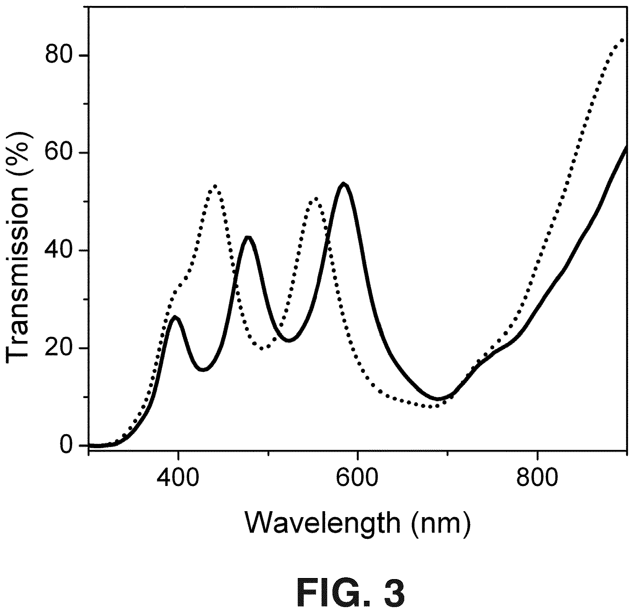

Figure 3 is a graph comparing the light transmission curves of two different examples of the semi transparent photovoltaic cell of the present invention. Layers 1 to 6 are the same in both examples. To tune the color of the device a different multilayer structure is used in each case. Both cells exhibit a similar efficiency. The solid line corresponds to the transmission of a cell that would appear reddish in color, the sequence of layers in the multilayer structure is first layer: 136 nm of Mo03, second layer: 136 nm of MgF2, third layer: 136 nm of Mo03, fourth layer: 68 nm of MgF2, and fifth layer 68 nm of Mo03. The dotted line corresponds to the transmission of a cell that would appear bluish in color, the sequence of layers in the multilayer structure is first layer: 102 nm of Mo03, second layer: 136 nm of MgF2, third layer: 102 nm of Mo03, fourth layer: 136 nm of MgF2, and fifth layer 68 nm of Mo03.
As it can be seen in the figure the transmission window can be shifted when the thickness of the layers in the multilayer structure is changed. This causes a change in the color of the device but almost no change in the photon collection efficiency of the device.

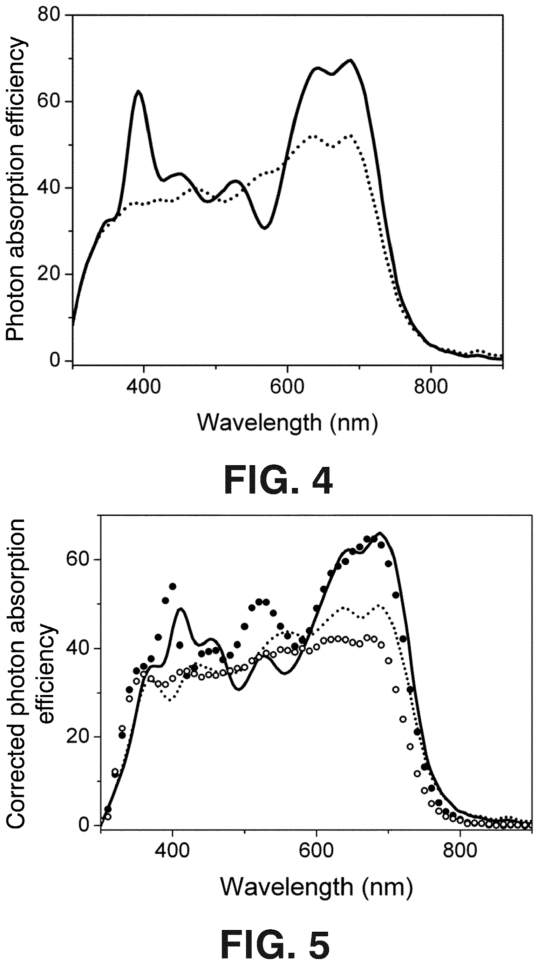

Figure 4 is a graph comparing the photon absorption by the invention (solid line) and by a semi-transparent cell which does not include the multilayer structure. The absorbed photons are proportional to the photo-carrier generation efficiency. For this graph, the embodiment of the invention comprises: a 1.1 mm thick Si02 substrate, a first semi-transparent 120 nm thick ITO electrode, an electron blocking layer of 10 nm thick Mo03, an active material made of a 90 nm blend of PTB7:PC₇₁BM, a hole blocking layer of a thickness of 3.5 nm made of BCP, a second semi-transparent electrode made of Ag and 10 nm thick, and the multilayer structure. The latter comprises five layers: 146 nm of Mo03, 102 nm of MgF2, 102 nm of Mo03, 102 nm of MgF2, and 102 nm of Mo03. The semi-transparent cell without the multilayer structure (dotted line) is composed of the same elements and a protective layer of Mo03 10 nm thick, but is not provided with the multilayer structure.
In this other example, the device of the present invention includes a direct cell. As in the example of Figure 2, photon absorption by the invention is enhanced for the wavelengths of the light to which the human eye is most insensitive. Again, photon absorption by the invention, in the wavelength range (400-600 nm) where the eye sensitivity is the largest, is similar to photon absorption by the semi-transparent cell which does not include the multilayer structure.

Figure 5 is a graph comparing the photon absorption by the invention (solid line is the theoretical prediction and the solid dots correspond to the experimental measurement) with a semi-transparent cell which does not include the multilayer structure. In this figure, the photon absorption efficiency has been multiplied by 0.94. By doing so, one accounts for the 94% efficiency in collection of electron-hole pairs from absorbed photons. Then, the corrected photon absorption efficiency (y-axis) is equivalent to the photo-charge collection efficiency, which is the experimentally measured quantity. For this graph, the embodiment of the invention comprises: a 1.1 mm thick Si02 substrate, a first semi-transparent 330 nm thick ITO electrode, an electron blocking layer of 30 nm thick PEDOT:PSS, an active material made of a 90 nm blend of PTB7:PC₇₁BM, a hole blocking layer of a thickness of 3.5 nm made of BCP, a second semi-transparent electrode made of Ag and 10 nm thick, and the multilayer structure. The latter comprises six layers: 15 nm of LiF, 136 nm of Mo03, 102 nm of LiF, 102 nm of Mo03, 136 nm of LiF, and 102 nm of Mo03. The semi-transparent cell without the multilayer structure (dotted line is the theoretical prediction and the open circles correspond to the experimental measurement) is composed of the same elements and a protective layer overlaying the second electrode of LiF 15 nm thick, but is not provided with the multilayer structure. Here, it can be observed that the corrected photon absorption efficiency by the invention is enhanced for light wavelengths to which the human eye is most insensitive. In this example, the theoretical prediction is supported by experimental data.

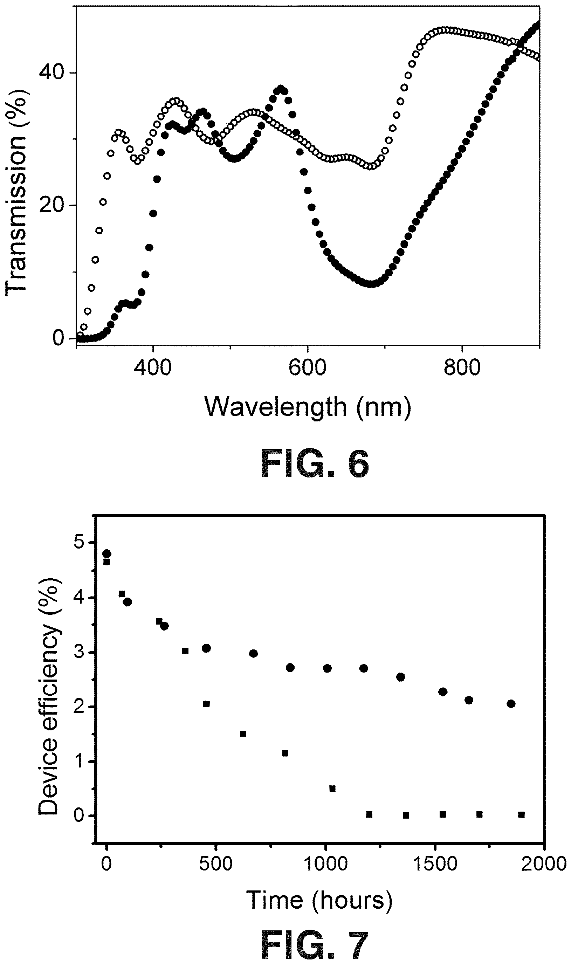

Figure 6 is a graph comparing the experimentally measured transmission of the invention (solid dots) with a semi-transparent cell which does not include the multilayer structure (open circles). For this graph, the embodiment of the invention comprises: a 1.1 mm thick Si02 substrate, a first semi-transparent 330 nm thick ITO electrode, an electron blocking layer of 30 nm thick PEDOT:PSS, an active material made of a 90 nm blend of PTB7:PC₇₁BM, a hole blocking layer of a thickness of 3.5 nm made of BCP, a second semi-transparent electrode made of Ag and 10 nm thick, and the multilayer structure. The latter comprises six layers: 15 nm of LiF, 136 nm of Mo03, 102 nm of LiF, 102 nm of Mo03, 136 nm of LiF, and 102 nm of Mo03. The semi-transparent cell without the multilayer structure is composed of the same elements and a protective layer of LiF 15 nm thick overlaying the second electrode, but is not provided with the multilayer structure. Note that the sequence of layers for the devices considered in this Figure is the same as for the devices considered in Figure 5. In other words, the transmission in solid dots in this Figure and the absorption in solid dots from Figure 5 correspond to the same devices of the invention, and the transmission in open circles in this Figure and the absorption in open circles from Figure 5 correspond to the same semi-transparent cell which does not include the multilayer structure. Note that the device of the invention opens a window of transmission in the wavelength range (400-600 nm) where the eye sensitivity is the largest while it keeps a small transmission to enhance light absorption by the photovoltaic cell for those wavelengths in the 300-400 nm and 600-700 nm ranges to which the human eye is least sensitive.

Figure 7 is a graph comparing the lifetime of the invention (solid circles) and of a semi-transparent cell which does not include the multilayer structure (solid squares). The sequence of layers for the devices considered in this Figure is the same as for the devices considered in Figure 2. In other words, the lifetime in solid squares in this Figure and the absorption in a solid line from Figure 2 correspond to the same devices of the invention, and the transmission in solid squares in this Figure and the absorption in the dotted line from Figure 2 correspond to the same semi-transparent cell which does not include the multilayer structure. As can be seen in this Figure, the semi-transparent cell which does not include the multilayer structure becomes non-operational after approximately 1200 hours. On the other hand, the device of the invention exhibits a significantly larger lifetime because the multilayer provides a better protection against corrosive elements such as oxygen or moisture. In the same time-lapse the device of the invention retains about 60% of the original performance level.

## Claims

1. A photoconversion device comprising a transparent substrate (1) and a first light transmissive electrical contact (2) overlaying the transparent substrate, a first charge blocking layer (3), an absorption layer comprising and active organic photosensitive material (4), a second charge blocking layer (5) overlying the active organic photosensitive material, a second light transmissive electrical contact (6) and a multilayer structure (7) in this order, wherein the multilayer structure comprises at least two layers of different dielectric materials with different index of refraction and wherein the thickness of each layer is between 5 and 500 nm and two adjacent layers in (7) have different refractive indexes, **characterized in that** the multilayer structure (7) comprises five layers of MoO3 and MgF2 in an alternating fashion or six layers of LiF and MoO3 in an alternating fashion.

2. The photoconversion device of claim 1 wherein the thickness of the charge blocking layers is between 1nm and 150nm.

3. The photoconversion device of claims 1 or 2 wherein the first charge blocking layer is a hole blocking layer comprising a semi-conductor layer of ZnO, PFN or TiO2 and the second blocking layer is an electron blocking layer comprising MoO3, PEDOT:PSS, WO3, NiO or a combination thereof .

4. The photoconversion device of claims 1 or 2 wherein the first charge blocking layer is an electron blocking layer comprising MoO3, PEDOT:PSS, WO3, NiO or a combination thereof and the second charge blocking layer is a hole blocking layer comprising ZnO, PFN, BCP, TiO2, LiF, LiCo02 or a combination thereof.

5. The photoconversion device of any of the preceding claims wherein the first and second transparent electrodes comprise one or a combination of the following:
- a metal layer or nanowire mesh comprising Ag, Al, Au, Ti, Ni, Cu, or a combination of these metals,
- a transparent conductive oxide layer comprising ITO, ZnO, Al:ZnO, SnO2, FTO, or a combination of these oxides,
- conductive polymers such as PEDOT, PEDOT:PSS, PEDOT-TMA or a carbon nanotube, or a graphene layer

6. The photoconversion device of any preceding claim wherein the absorption layer (4) comprises a blend that contains a mixture of a semiconductor conjugated polymer and a fullerene compound.

7. The photoconversion device of any of the preceding claims wherein the absorption layer (4) comprises a stack of two or more blends forming a tandem organic active layer in a series configuration.

## Patentansprüche

1. Eine Fotowandlereinrichtung, umfassend ein transparentes Substrat (1) und einen ersten lichtdurchlässigen elektrischen Kontakt (2), welcher das transparente Substrat überlagert, eine erste Ladungssperrschicht (3), eine Absorptionsschicht umfassend ein aktives organisches fotosensitives Material (4), eine zweite Ladungssperrschicht (5), welche das aktive organische fotosensitive Material überlagert, ein zweiter lichtdurchlässiger elektrischer Kontakt (6) und eine Mehrschichtstruktur (7) in dieser Reihenfolge,
wobei die Mehrschichtstruktur mindestens zwei Schichten mit verschiedenen dielektrischen Materialien mit verschiedenen Brechungsindexen umfasst und wobei die Dicke jeder Schicht zwischen 5 und 500 nm ist und zwei benachbarte Schichten der Mehrschichtstruktur (7) verschiedene Brechungsindices aufweisen,
**dadurch gekennzeichnet, dass**
die Mehrschichtstruktur (7) fünf Schichten von MoO₃ und MgF₂ in alternierender Weise oder sechs Schichten von LiF und MoO₃ in alternierender Weise umfasst.

2. Die Fotowandlereinrichtung nach Anspruch 1, wobei die Dicke der Ladungssperrschichten zwischen 1nm und 150nm liegt.

3. Die Fotowandlereinrichtung nach Anspruch 1 oder 2, wobei die erste Ladungssperrschicht eine Lochsperrschicht ist, umfassend eine Halbleiterschicht aus ZnO, PFN oder TiO₂ und die zweite Ladungssperrschicht eine Elektronensperrschicht ist, umfassend MoO₃, PEDOT:PSS, WO₃, NiO oder eine Kombination hieraus.

4. Die Fotowandlereinrichtung nach Anspruch 1 oder 2, wobei die erste Ladungssperrschicht eine Elektronensperrschicht ist, umfassend MoO₃, PEDOT:PSS, WO₃, NiO oder eine Kombination hieraus und die zweite Ladungssperrschicht eine Lochsperrschicht ist, umfassend eine Halbleiterschicht aus ZnO, PFN, BCP, TiO₂, LiF, LiCoO₂ oder einer Kombination hieraus.

5. Die Fotowandlereinrichtung nach einem der vorangegangen Ansprüche, wobei die erste und die zweite transparente Elektrode eines der Folgenden oder eine Kombination der Folgenden umfassen:
- eine Metallschicht oder ein Nanodrahtgeflecht, umfassend Ag, Al, Au, Ti, Ni, Cu oder eine Kombination dieser Metalle,
- eine transparente leitfähige Oxidschicht, umfassend ITO, ZnO, Al:ZnO, SnO₂, FTO oder eine Kombination aus diesen Oxiden,
- ein leitfähiges Polymer, beispielsweise PEDOT, PEDOT:PSS, PEDOT-TMA, oder Kohlenstoff-Nanoröhren oder eine Graphenschicht.

6. Die Fotowandlereinrichtung nach einem der vorangegangen Ansprüche, wobei die Absorptionsschicht (4) eine Mischung aufweist, welche ein Gemisch aus Halbleiter konjugiertem Polymer und eine Fullerenverbindung umfasst.

7. Die Fotowandlereinrichtung nach einem der vorangegangen Ansprüche, wobei die Absorptionsschicht (4) einen Stapel aus zwei oder mehr Gemischen aufweist, welche eine organisch aktive Tandemschicht in einer Serienkonfiguration ausbilden.

## Revendications

1. Dispositif de photoconversion comprenant un substrat transparent (1) et un premier contact électrique (2) transmettant la lumière, qui recouvre le substrat transparent, une première couche de blocage de charge (3), une couche d'absorption comprenant un matériau photosensible organique actif (4), une deuxième couche de blocage de charge (5) qui recouvre le matériau photosensible organique actif, un deuxième contact électrique (6) transmettant la lumière et une structure multicouche (7), dans cet ordre ; dans lequel la structure multicouche comprend au moins deux couches de matériaux diélectriques différents possédant des indices de réfraction différents, et dans lequel l'épaisseur de chaque couche se situe entre 5 et 500 nm, et deux couches adjacentes dans (7) possèdent des indices de réfraction différents ; **caractérisé en ce que** la structure multicouche (7) comprend cinq couches de MoO₃ et de MgF₂ de manière alternée ou six couches de LiF et de MoO₃ de manière alternée.

2. Dispositif de photoconversion selon la revendication 1, dans lequel l'épaisseur des couches de blocage de charge se situe entre 1 nm et 150 nm.

3. Dispositif de photoconversion selon la revendication 1 ou 2, dans lequel la première couche de blocage de charge représente une couche de blocage de trous comprenant une couche faisant office de semi-conducteur à base de ZnO, de PFN ou de TiO₂ et la deuxième couche de blocage représente une couche de blocage d'électrons comprenant du MoO3, du PEDOT:PSS, du WO₃, du NiO ou une de leurs combinaisons.

4. Dispositif de photoconversion selon la revendication 1 ou 2, dans lequel la première couche de blocage de charge représente une couche de blocage d'électrons comprenant du MoO3, du PEDOT:PSS, du WO₃, du NiO ou une de leurs combinaisons et la deuxième couche de blocage de charge représente une couche de blocage de trous comprenant du ZnO, du PFN, du BCP, du TiO₂, du LiF, du LiCoO₂ ou une de leurs combinaisons.

5. Dispositif de photoconversion selon l'une quelconque des revendications précédentes, dans lequel la première et la deuxième électrode transparente comprennent un des éléments ci-après ou une de leurs combinaisons, à savoir :
- une couche métallique ou une maille de nanofils comprenant Ag, Al, Au, Ti, Ni, Cu, ou une combinaison de ces métaux ;
- une couche d'oxyde conductrice transparente comprenant ITO, ZnO, Al:ZnO, SnO₂, FTO ou une combinaison de ces oxydes ;
- des polymères conducteurs tels que PEDOT, PEDOT:PSS, PEDOT-TMA ou un nanotube en carbone ou une couche de graphène.

6. Dispositif de photoconversion selon l'une quelconque des revendications précédentes, dans lequel la couche d'absorption (4) comprend un assemblage qui contient un mélange d'un polymère conjugué faisant office de semi-conducteur et d'un composé de fullerène.

7. Dispositif de photoconversion selon l'une quelconque des revendications précédentes, dans lequel la couche d'absorption (4) comprend un empilement de deux assemblages ou plus, qui forme une couche organique active en tandem dans une configuration en série.
